Europäisches Patentamt

European Patent Office

Office européen des brevets

(19)

(11) Numéro de publication: **0 054 452**
**B1**

(12)

# FASCICULE DE BREVET EUROPEEN

(45) Date de publication du fascicule du brevet: **20.06.84**   (51) Int. Cl.³: **H 04 N 3/20**

(21) Numéro de dépôt: **81401786.9**

(22) Date de dépôt: **10.11.81**

(54) Dispositif de protection d'un récepteur de télévision, et téléviseur comportant un tel dispositif.

(30) Priorité: **12.12.80 FR 8026419**

(43) Date de publication de la demande:
**23.06.82 Bulletin 82/25**

(45) Mention de la délivrance du brevet:
**20.06.84 Bulletin 84/25**

(84) Etats contractants désignés:
**DE GB IT**

(56) Documents cités:
**US - A - 3 374 391**
**US - A - 3 784 870**
**US - A - 3 811 068**

(73) Titulaire: **SOCIETE D'ELECTRONIQUE DE LA REGION PAYS DE LOIRE SEREL**
**74, rue du Surmelin**
**F-75020 Paris (FR)**

(72) Inventeur: **Guillon, Jean-Claude**
**THOMSON-CSF SCPI 173, bld Haussmann**
**F-75360 Paris Cedex 08 (FR)**
Inventeur: **Potin, Michel**
**THOMSON-CSF SCPI 173, bld Haussmann**
**F-75360 Paris Cedex 08 (FR)**

(74) Mandataire: **Grynwald, Albert et al,**
**THOMSON-CSF SCPI 173, Bld Haussmann**
**F-75379 Paris Cedex 08 (FR)**

Courier Press, Leamington Spa, England.

## Description

L'invention est relative à un dispositif de protection interrompant, en cas d'incident, le fonctionnement du circuit de balayage horizontal d'un récepteur de télévision, notamment du type transistorisé en couleurs, ainsi qu'à un récepteur de télévision comprenant un tel dispositif.

On sait qu'en télévision, l'image est obtenue par un déplacement d'un point selon des lignes, de gauche à droite et de haut en bas, sur l'écran enduit de substances luminophores. Le point est l'impact d'un pinceau d'électrons, dont l'intensité est fonction de l'intensité lumineuse du point à reproduire, contre les substances luminophores de l'écran et le balayage de l'écran est obtenu par déplacement du pinceau d'électrons. Ce déplacement est provoqué par des champs magnétiques variables engendrés par des bobines parcourues par des courants dont l'intensité varie en fonction du temps sensiblement en dents de scie. Une bobine commande le déplacement horizontal et une autre bobine commande le déplacement vertical.

L'énergie d'alimentation du déviateur vertical et du canon à électrons sont en général tirées des impulsions de retour ligne, c'est-à-dire de la surtension apparaissant aux bornes de la bobine de déviation horizontale lors de la brusque variation de l'intensité du courant dans cette bobine, au cours des retours de lignes (balayage rapide de l'écran de droite à gauche).

C'est pourquoi les dispositifs de protection automatique des téléviseurs agissent, en cas d'incident, sur le circuit d'alimentation du balayage horizontal afin de le bloquer et ainsi d'interrompre simultanément les balayages horizontal et vertical et le fonctionnement du canon à électrons.

L'invention vise une réalisation particulièrement simple et économique d'un tel dispositif de protection.

Le dispositif de protection selon l'invention, comprenant des moyens détecteurs émettent un signal en cas d'incident, et un moyen pour que ce signal d'incident affecte la charge d'un condensateur faisant partie de moyens de temporisation en vue de n'interrompre le circuit qu'après détection d'un défaut d'une durée au moins égale à un temps (t) prédéterminé qui est représentée par la tension aux bornes dudit condensateur, est caractérisé en ce que lesdits moyens détecteurs comportent des moyens pour que le condensateur se charge, lors de l'apparition d'un défaut, seulement quand surviennent des impulsions périodiques de courte durée par rapport à la période. La capacité de ce condensateur peut ainsi être faible.

Dans le mode de réalisation préféré, on prévoit un moyen d'auto-maintien pour maintenir le blocage du balayage horizontal tant que l'alimentation générale du téléviseur n'a pas été interrompue. On évite ainsi une possible répétition de blocages et de remises en fonctionnement qui pourrait détruire des composants des circuits du téléviseur, notamment les composants de puissance.

D'autres caractéristiques de l'invention apparaîtront avec la description de certains de ses modes de réalisation, celle-ci étant effectuée en se référant aux dessins ci-annexés sur lesquel:

— la figure 1 est un schéma d'un circuit de balayage vertical auquel s'applique l'invention,

— la figure 2 est un dispositif de protection pour le circuit de la figure 1, et

— la figure 3 montre une réalisation détaillée du dispositif de la figure 2.

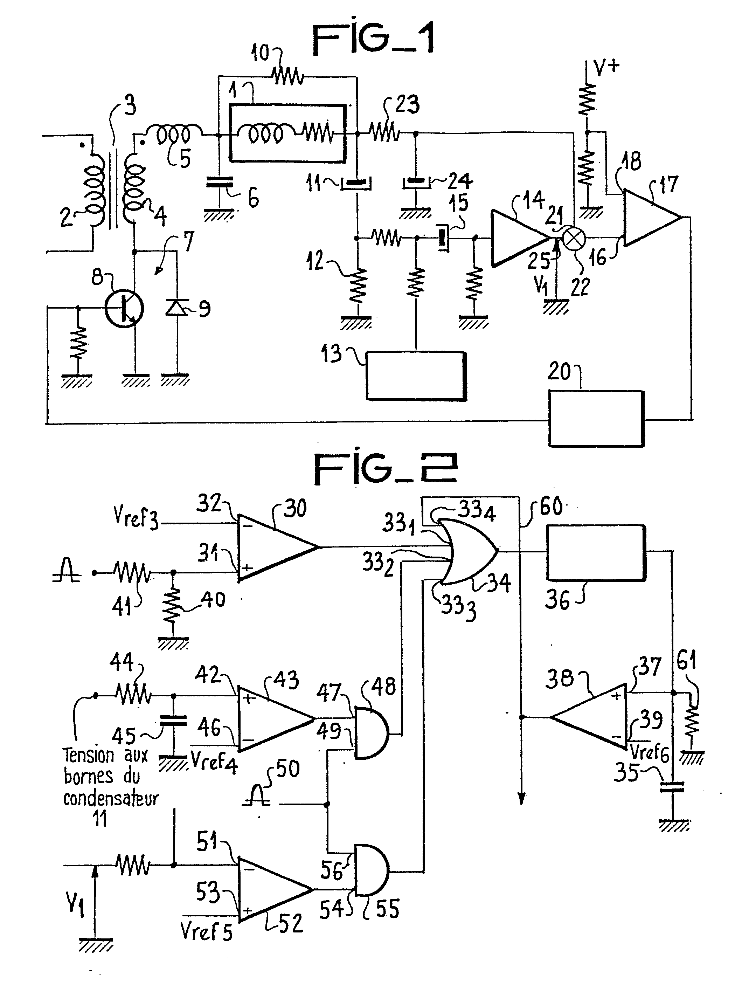

Le circuit représenté sur la figure 1 est un circuit de balayage vertical pour un récepteur de télévision qui comprend une bobine 1 de déviation verticale et des moyens pour que cette bobine soit alimentée par un courant en dents de scie affectées de corrections, telle qu'une correction en S. Ce circuit est du type de celui décrit dans ·la demande de brevet européen EP—A1—0 008 263 au nom de la demanderesse.

L'energie destinée à produire ce courant d'alimentation de la bobine 1 est tirée de la surtension apparaissant aux bornes de la bobine de déviation horizontale (non montrée) lors des périodes de retour ligne. Ces impulsions sont recueillies aux bornes de l'enroulement primaire 2 d'un transformateur 3 appelé "transformateur-ligne" qui comporte un enroulement secondaire 4 alimentant un circuit LC à inductance 5 et condensateur 6 disposé de telle manière qu'une borne de l'inductance 5 soit reliée directement à une borne de l'enroulement 4 et une armature du condensateur 6 soit à la masse. L'autre borne de l'enroulement 4 est reliée à la masse par l'intermédiaire d'un interrupteur actif 7 comprenant, d'une part, un transistor 8 de type NPN dont l'émetteur est à la masse et d'autre part une diode 9 branchée en sens inverse de transistor 8, c'est-à-dire dont l'anode est à la masse.

On applique sur la base du transistor 8 des signaux tels que celui-ci soit conducteur, à chaque période de balayage horizontal, pendant un temps qui est fonction du numéro de la ligne balayée à ce moment, de manière à obtenir la forme désirée pour le courant dans le déviateur 1.

En parallèle sur le déviateur 1 est disposée une résistance 10.

Ce déviateur est en série avec un condensateur chimique 11 et une résistance 12 appelée résistance de mesure. La borne de la résistance 12 opposée au condensateur est à la masse, l'ensemble formé par le déviateur 1, le condensateur 11 et la résistance 12 étant ainsi en parallèle sur le condensateur 6. Le condensateur 11 est tel que la tension aux bornes dudit ensemble garde toujours la même polarite, ce condensateur se comportant ainsi alternativement en générateur en en récepteur d'énergie.

La conduction du transistor 8 est commandée à l'aide d'un oscillateur 13, appelé "oscillateur trame", délivrant des signaux en dents de scie représentant le corant désiré dans le déviateur 1. Cet oscillateur 13 est relié à l'entrée d'un amplificateur 14 par l'intermédiaire d'un condensateur 15. La sortie de l'amplificateur 14 est connectée à la première entrée 16 d'un comparateur 17 sur la seconde entrée 18 duquel est appliqué un signal de potentiel constant et dont la sortie est reliée à la base du transistor 8 par l'intermédiaire d'un convertisseur tension-temps 20.

La tension aux bornes de la résistance 12, qui représente le courant traversant le déviateur 1, est appliquée sur l'entrée de l'amplificateur 14, aussi par l'intermédiaire du condensateur 15. On obtient ainsi une régulation, le signal de contre-réaction, ou signal de mesure, étant la tension aux bornes de la résistance 12.

La tension moyenne aux bornes du condensateur 11 est maintenue constante, avec une valeur déterminée pour que l'écran soit balayé complètement. A cet effet une tension de référence est appliquée sur l'entrée 18 du comparateur 17 et on prévoit une boucle d'asservissement appelée "boucle statique". Le signal de mesure de cette boucle est la tension aux bornes du condensateur 11; cette tension est appliquée sur l'entrée 21 d'un sommateur de tensions 22 par l'intermédiaire d'un filtre passe-bas à résistance 23 et condensateur 24. Le sommateur 22 présente une seconde entrée 25 reliée à la sortie de l'amplificateur 14 et sa sortie est connectée à l'entrée 16 du comparateur 17.

On se référe maintenant à la figure 2 qui représente un dispositif de protection selon l'invention.

Ce dispositif permet de surveiller la très haute tension (THT) fournie au tube cathodique, la tension aux bornes du condensateur 11 en série avec le déviateur 1, et la présence ou l'absence de courant dans ce déviateur et permet d'interrompre le balayage horizontal en cas d'incident détecté.

Une telle surveillance est rendue nécessaire par les risques encourus par les utilisateurs et les risques de détérioration du téléviseur en cas d'incident. En effet, si la THT devient trop importante, un rayonnement X, dangereux pour les spectateurs, est émis. Si la tension aux bornes du condensateur 11 est trop élevée, ce dernier risque de se détériorer. Si le courant dans le déviateur vertical disparaît, le pinceau électronique ne balaie qu'une ligne sur l'écran ce qui risque de détériorer, par chauffage excessif, les substances luminophores sur cette ligne.

Lorsque la THT et/ou la tension aux bornes du condensateur 11 dépasse une valeur déterminée pendant un tempts t, l'oscillateur commandant le balayage horizontal est bloqué, ce qui supprime ce balayage horizontal; ainsi, la très haute tension disparait, de même que la charge du condensateur 11. L'oscillateur de commande du balayage horizontal est également bloqué lorsque le courant dans le déviateur 1 a disparu pendant une durée au moins égale à t.

La très haute tension d'alimentation est fournie par un tripleur de tension qui multiplie par trois la tension de retour ligne. Pour surveiller cette THT il suffit donc de surveiller la tension de retour ligne. A cet effect, on prévoit un comparateur 30 (figure 2) dont l'entrée 31(+) reçoit un signal proportionnel au signal de retour ligne et dont l'autre entrée 32(—) reçoit une tension de référence Vref3. La sortie du comparateur 30 est reliée à une première entrée $33_1$ d'une porte OU 34. Les impulsions de retour ligne appliquées sur l'entrée 31 sont obtenues par exemple en connectant cette entrée à un enroulement secondaire du transformateur 3 par l'intermédiaire d'un diviseur de tension à résistances 40 et 41. Cet enroulement secondaire est par exemple celui prévu pour produire les impulsions de synchronisation de l'oscillateur commandant le balayage horizontal.

Le signal de sortie de la porte OU 34 est utilisé pour charger un condensateur mémoire ou condensateur tampon 35. A cet effet, un convertisseur tension-courant 36 est interposé entre la sortie de la porte 34 et une armature du condensateur 35. L'autre armature de ce condensateur est à la masse.

La tension. aux bornes du condensateur 35 est appliquée sur l'entrée 37 (+) d'un comparateur 38 sur la seconde entrée 39 (—) duquel est appliquée une tension de référence Vref6. La sortie de ce comparateur 38 est reliée à une entrée de blocage de l'oscillateur commandant le circuit de balayage horizontal (non représenté).

Lorsque la tension aux bornes du condensateur 35 dépasse la valeur Vref6 un signal de commande de blocage dudit oscillateur apparaît sur la sortie du comparateur 38.

La tension aux bornes du condensateur de liaison 11 est appliquée sur l'entrée 42 (+) d'un comparateur 43 par l'intermédiaire d'un filtre passe-bas à résistance 44 et condensateur 45. Sur l'entrée 46 (—) dudit comparateur 43 est appliquée une tension de référence Vref4.

La sortie du comparateur 43 est reliée à la première entrée 47 d'une porte ET 48 dont la seconde entrée 49 reçoit des impulsions 50 de retour ligne et dont la sortie est reliée à une seconde entrée $33_2$ de la porte OU 34.

Pour surveiller la présence ou l'absence de courant dans le déviateur 1, on fait appel à la surveillance de la tension aux bornes de la résistance de mesure 12 alors que dans les dispositifs de protection antérieurement connus, on surveillait la présence d'une tension très élevée aux bornes du déviateur 1 pendant la période de retour de balayage vertical.

De façon plus précise la présence du courant dans le déviateur 1 est surveillée à l'aide du signal de sortie de l'amplificateur 14. On se base en effet sur la constatation qu'en sortie de l'amplificateur 14 on obtient un signal d'erreur dynamique qui est de faible valeur en fonctionnement normal du circuit (présence de courant dans le déviateur 1) et a une forte amplitude lorsque la tension aux bornes de la résistance 12 est nulle. Dans ce dernier cas l'amplificateur 14 est saturé.

Ce signal $V_1$ de sortie de l'amplificateur 14 est appliqué sur l'entrée 51 (−) d'un autre comparateur 52 sur l'entrée 53 (+) duquel est appliquée une tension de référence Vref5. La sortie de ce comparateur 52 est reliée à la première entrée 54 d'une porte ET 55 dont la seconde entrée 56 reçoit, comme l'entrée 49 de la porte 48, les signaux de retour ligne 50.

La sortie de la porte ET 55 est connectée à une troisième entrée $33_3$ de la porte OU 34.

Une connexion 60 est établie entre la sortie du comparateur 38 et une quatrième entrée $33_4$ de la porte OU 34.

La capacité du condensateur 35 est fonction du temps t de temporisation au bout duquel l'oscillateur de balayage horizontal est bloqué après apparition d'un défaut. Pour un même temps t cette capacité est beaucoup plus faible lorsque le condensateur n'est chargé que pendant les périodes de retour ligne (grâce aux portes 48 et 55 et au fait que sur l'entrée 31 du comparateur 30 sont appliquées des impulsions en synchronisme avec les impulsions de retour ligne) que lorsque ce condensateur est chargé en permanence. Son prix et son encombrement sont donc réduits.

La connexion 60 permet un maintien automatique du blocage de l'oscillateur de commande du balayage horizontal après détection d'un défaut. En effet, dans ce cas cette connexion permet de continuer à charger le condensateur 35, c'est-à-dire de maintenir la tension à ses bornes à une valeur supérieure à la tension Vref6.

Pour supprimer ce blocage automatique il est nécessaire de décharger le condensateur 35. Cette décharge n-intervient qu'après coupure de l'alimentation générale du téléviseur.

On prévoit une résistance 61 de forte valeur en parallèle sur le condensateur 35 pour dériver les éventuels courants de fuite issus du convertisseur 36 et pour évacuer les charges fournies à ce condensateur pendant les périodes transitoires.

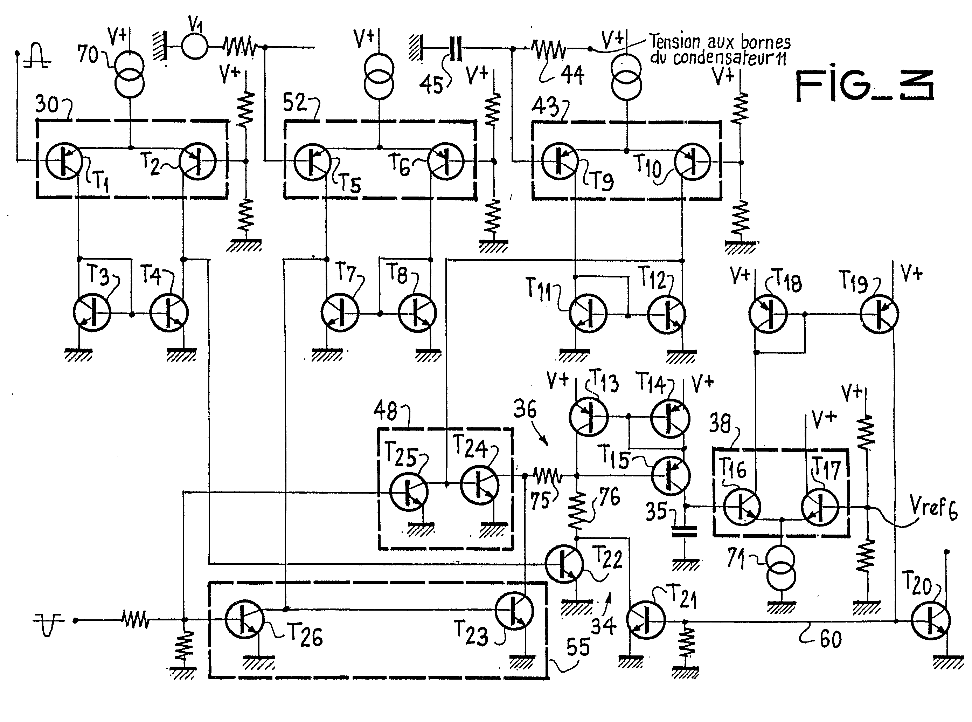

La figure 3 est un schéma de réalisation en circuit intégré du dispositif représenté sur la figure 2.

Dans cet exemple les divers comparateurs comprennent chacun deux transistors. Ainsi les comparateurs 30, 52 et 43 comportent chacun deux transistors de type PNP, respectivement $T_1, T_2; T_5, T_6;$ et $T_9, T_{10}$. Les émetteurs des paires de transistors de ces comparateurs sont reliés chacun à la sortie d'un générateur de courant 70 alimenté par une tension V+.

Les entrées desdits comparateurs 30, 52 et 43 sont les bases de transistors.

A chacune des paires de transistors $T_1, T_2; T_5, T_6; T_9, T_{10}$ est associée une autre paire de transistors, respectivement $T_3, T_4; T_7, T_8; T_{11}, T_{12}$ constituant chacun un miroir de courant.

Les transistors $T_3$ et $T_4$ sont du type NPN. Leurs émetteurs sont à la masse. Leurs bases sont reliées entre elles et le collecteur du transistor $T_3$ est connecté à sa base ainsi qu'au collecteur du transistor $T_1$. Le collecteur du transistor $T_4$ est relié au collecteur du transistor $T_2$.

La sortie du comparateur 30 est reliée au collecteur des transistors $T_4$ et $T_2$.

La sortie du comparateur 52 est reliée au collecteur des transistors $T_5$ et $T_7$ et la sortie du comparateur 43 est reliée au collecteur des transistors $T_{10}$ et $T_{12}$.

La porte ET 48 est constituée de deux transistors NPN $T_{24}$ et $T_{25}$. De même, la porte ET 55 comporte deux transistors NPN $T_{23}$ et $T_{26}$.

La porte OU 34 comprend des transistors NPN $T_{21}$ et $T_{22}$ ainsi que des résistance 75 et 76 et le convertisseur 36 comporte des transistors $T_{13}, T_{14}$ et $T_{15}$ formant un miroir de courant chargeant le condensateur 35.

Le comparateur 38 comporte deux transistors NPN $T_{16}$ et $T_{17}$ dont les émetteurs sont reliés ensemble à une borne d'un générateur de courant 71 dont l'autre borne est à la masse. Le collecteur du transistor $T_{17}$ reçoit une tension V+ et c'est sur la base de ce transistor $T_{17}$ qu'est appliquée la tension de référence Vref6.

Le signal de sortie est recueilli sur le collecteur d'un transistor $T_{20}$ de type NPN dont la base est reliée à la sortie du comparateur 38, constituée par le collecteur du transistor $T_{16}$, par l'intermédiaire de deux transistors $T_{18}$ et $T_{19}$ associés en miroir de courant. La base du transistor $T_{20}$ est également reliée à la base du transistor $T_{21}$ par la connexion 60.

La plupart des composants du dispositif selon l'invention peuvent avantageusement faire partie du même circuit intégré que celui prévu pour la commande du balayage vertical qui comporte notamment l'amplificateur 14 et le comparateur 17. Un tel circuit intégré assurant à la fois la commande du balayage vertical et la protection du récepteur de télévision ne comporte qu'une ou deux bornes de plus—en particulier celle prévue pour la mesure de la tension aux bornes du condensateur 35—qu'un circuit intégré prévu seulement pour la commande du balayage vertical.

**Revendications**

1. Dispositif de protection d'un récepteur de télévision interrompant l'alimentation d'un circuit de ce récepteur en cas d'incident, ce dispositif comprenant des moyens détecteurs (30, 43, 52, 48, 55, 34) émettant un signal en cas d'incident, et un moyen (36) pour que ce signal d'incident affecte la charge d'un condensateur (35) faisant partie de moyens de temporisation (35, 38) pour n'interrompre le circuit qu'aprés détection d'un défaut d'une durée au moins égale à un temps (t) prédéterminé qui est représentée par la tension aux bornes dudit condensateur (35), caractérisé en ce que lesdits moyens détecteurs comportent des moyens (30, 43, 52, 48, 55, 34) pour que le condensateur (35) se charge, lors de l'apparition d'un défaut, seulement quand surviennent des impulsions périodiques de courte durée par rapport à la période.

2. Dispositif selon la revendication 1, caractérisé en ce que les impulsions sont les impulsions de retour de balayage horizontal.

3. Dispositif selon la revendication 1 ou 2, caractérisé en ce que le circuit interrompu en cas d'incident est le circuit de balayage horizontal.

4. Dispositif selon l'une quelconque des revendications 1 à 3, caractérisé en ce que le moyen de temporisation comporte un comparateur (38) commandant l'interruption du circuit lorsque la tension aux bornes dudit condensateur (35) dépasse une valeur (Vref6) déterminée.

5. Dispositif selon l'une quelconque des revendications précédentes, caractérisé en ce qu'il comporte des détecteurs de défauts engendrant des signaux appliqués sur des entrées respectives ($33_1$ à $33_3$) d'une porte OU (34) transmettant ces signaux au condensateur (35) par l'intermédiaire d'un convertisseur (36) tension-courant.

6. Dispositif selon l'une quelconque des revendications précédentes, caractérisé en ce qu'il comprend un moyen (60) pour maintenir l'interruption de l'alimentation du circuit après détection d'un défaut d'une durée supérieure audit temps t.

7. Dispositif selon les revendications 5 et 6, caractérisé en ce que la sortie du comparateur (38) est reliée à une entrée supplémentaire ($33_4$) de la porte OU (34).

8. Dispositif selon l'une quelconque des revendications précédentes, caractérisé en ce qu'un condensateur de liaison (11) est en série avec le déviateur vertical (1), et en ce que le dispositif comporte un moyen (43) pour émettre un signal de détection de défaut lorsque la tension moyenne aux bornes dudit condensateur de liaison dépasse un value prédéterminée.

9. Dispositif selon l'une quelconque des revendications précédentes, caractérisé en ce qu'une résistance de mesure (12) étant en série avec le déviateur vertical (1) il comporte un moyen (52) pour engendrer un signal de défaut lors de la disparition de la tension aux bornes de ladite résistance.

10. Dispositif selon la revendication 9, caractérisé en ce que le courant dans le déviateur vertical (1) étant asservi au signal produit par un oscillateur (13), le signal d'erreur du circuit d'asservissement étant fonction de la différence entre le signal de consigne produit par l'oscillateur et la tension aux bornes de la résistance de mesure (12, il comporte un moyen (52) pour produire un signal de défaut lorsque le signal d'erreur dépasse une valeur déterminée.

11. Dispositif selon la revendication 10, caractérisé en ce que la valeur excessive du signal d'erreur est détectée par la saturation d'un amplificateur (14).

12. Dispositif selon les revendications 8 et 9 caractérisé en ce que les sorties desdits moyens (43, 52) émetteurs de signaux de détection de défauts sont reliées aux premières entrées (47, 54) de deux portes ET (48, 55) dont les secondes entrées (49, 56) reçoivent un signal d'impulsions (50) de courte durée par rapport à la période, notamment des impulsions de retour de balayage horizontal, les sorties de ces portes ET (48, 55) étant reliées à des entrées respectives ($33_2$, $33_3$) d'une porte OU (34) dont la sortie est connectée audit condensateur (35) par l'intermédiaire d'un convertisseur (36) tension-courant.

13. Dispositif selon l'une quelconque des revendications précédentes, caractérisé en ce qu'il comporte un moyen (30) pour émettre un signal de défaut lorsque la très haute tension (THT) atteint une valeur excessive, la surveillance de cette THT étant effectuée par la surveillance de l'amplitude des impulsions de retour de balayage ligne.

14. Dispositif selon l'une quelconque des revendications précédentes, caractérisé en ce qu'au moins certains de ses composants font partie d'un circuit intégré comportant également des composants du dispositif de commande du balayage vertical du récepteur de télévision.

15. Récepteur de télévision, caractérisé en ce qu'il comprend un dispositif selon l'une quelconque des revendications précédentes.

**Patentansprüche**

1. Schutzvorrichtung eines Fernsehempfangsgeräts, das bei einem Zwischenfall die Stromversorgung eines Schaltkreises dieses Empfangsgeräts unterbricht, wobei diese Vorrichtung Detektormittel (30, 43, 52, 48, 55, 34) enthält, die ein Signal im Fall eines Zwischenfalls aussenden, und ein Mittel (36) damit dieses Zwichenfallsignal auf die Ladung eines Kondensators (35) einwirkt, der Teil der Verzögerungsmittel (35, 38) ist, um den Schaltkreis nur nach Detektion eines Fehlers zu unterbrechen, der einer Dauer von wenigstens einer vorbestimmten Zeit (t) entspricht, welche durch die Klemmenspannung des besagten Kondensators (35) dargestellt wird, dadurch gekennzeichnet, dass die Detektionsmittel Mittel (30, 43, 52, 48, 55, 34) umfassen damit der Kondensator (35) beim Auftreten einer Störung sich nur dann lädt, wenn periodische Impulse von im Verhältnis zu der Periode kurzer Dauer dazukommen.

2. Vorrichtung nach Anspruch 1, dadurch gekennzeichnet, dass die Impulse die Impulse des Rücklaufs der horizontalen Ablenkung sind.

3. Vorrichtung nach Anspruch 1 oder 2, dadurch gekennzeichnet, dass der im Fall eines Zwischenfalls unterbrochene Schaltkreis der Schaltkreis der Horizontalablenkung ist.

4. Vorrichtung nach einem der Ansprüche 1 bis 3, dadurch gekennzeichnet, dass die Verzögerungsmittel einen Komparator (38) umfassen, der die Unterbrechung des Schaltkreises steuert, wenn die Klemmenspannung des Kondensators (35) einen bestimmten Wert (Vref6) überschreitet.

5. Vorrichtung nach einem der vorangehenden Ansprüche, dadurch gekennzeichnet, dass sie Störungsdetektoren umfasst, welche Signale erzeugen die an die jeweiligen Eingänge ($33_1$ bis $33_3$) eines ODER-Gatters (34) abgegeben werden, das diese Signale an den Kondensator (35) mit Hilfe eines Spannung/Strom-Konverters weiterleitet.

6. Vorrichtung nach einem der vorangehenden Ansprüche, dadurch gekennzeichnet, dass er ein Mittel (60) umfasst um die Unterbrechung der Stromversorgung nach Detektion einer Störung von einer grösseren Dauer als der Zeit t aufrecht zu erhalten.

7. Vorrichtung nach den Ansprüchen 5 und 6, dadurch gekennzeichnet, dass der Ausgang des Komparators (38) mit einem zusätzlichen Eingang ($33_4$) des ODER-Gatters (34) geschaltet ist.

8. Vorrichtung nach einem der vorangehenden Ansprüche, dadurch gekennzeichnet, dass ein Zwischenkondensator (11) mit der Einheit zur vertikalen Ablenkung (1) in Reihe geschaltet ist, und dadurch, dass die Vorrichtung ein Mittel (43) enthält um das Signal der Fehlerdetektion auszusenden, wenn die durchschnittliche Klemmenspannung des Zwischenkondensators einen vorgestimmten Wert überschreitet.

9. Vorrichtung nach einem der vorangehenden Ansprüche, dadurch gekennzeichnet, dass, wobei ein Messwiderstand (12) mit der Einheit zur vertikalen Ablenkung in Reihe geschaltet ist, sie ein Mittel (52) enthält um ein Störungssignal beim Ausfall der Klemmenspannung dieses Widerstands zu erzeugen.

10. Vorrichtung nach Anspruch 9, dadurch gekennzeichnet, dass, wobei der Strom in der Einheit zur vertikalen Ablenkung (1) nach einem von einem Oszillator (13) erzeugten Signal gesteuert wird, das Fehlersignal des Servosteuerkreis es dabei Funktion des Unterschieds zwischen dem von dem Oszillator erzeugten Sollwertsignal und der Klemmenspannung des Messwiderstands (12) ist, sie Mittel (52) umfasst um ein Störungssignal zu erzeugen, wenn das Fehlersignal einen vorbestimmten Wert überschreitet.

11. Vorrichtung nach Anspruch 10, dadurch gekennzeichnet, dass der übermässig erhöhte Wert des Fehlersignals durch die Sättigung eines Verstärkers (14) detektiert wird.

12. Vorrichtung nach dem Anspruchen 8 und 9, dadurch gekennzeichnet, dass die Ausgänge der Signale zur Detektion von Fehlern aussendenden Mittel (43, 52) mit den ersten Eingängen (47, 54) von zwei UND-Gattern (48, 55) geschaltet sind, deren zweiten Eingänge (49, 56) ein Impulssignal (50) von im Verhältnis zur Periode kurzen Dauer erhalten, besonders Impulse des Rückwegs der horizontalen Ablenkung, wobei die Ausgänge dieser UND-Gatter (48, 55) mit den jeweiligen Eingängen ($33_2$, $33_3$) eines ODER-Gatters (34) geschaltet sind, dessen Ausgang mit dem genannten Kondensator (35) mit Hilfe eines Spannung/Strom-Konverters (36) geschaltet ist.

13. Vorrichtung nach einem der vorangehenden Ansprüche, dadurch gekennzeichnet, dass er ein Mittel (3) enthält, um ein Fehlersignal auszusenden wenn die Höchstspannung einen übermässigen Wert erreicht, wobei die Überwachung dieser Höschstspannung durch die Überwachung der Amplitude der Impulse des Rückwegs der Zeilenablenkung vorgenommen wird.

14. Vorrichtung nach einem der vorangehenden Ansprüche, dadurch gekennzeichnet, dass wenigstens gewisse ihrer Komponenten Teil eines integrierten Schaltkreises sind, der ebenfalls Komponenten der Vorrichtung des Fernsehempfangsgeräts zur Steuerung der vertikalen Ablenkung umfasst.

15. Fernsehempfangsgerät, dadurch gekennzeichnet, dass es eine Vorrichtung nach einem der vorangehenden Ansprüche umfasst.

## Claims

1. Safety device for a television receiver interrupting the supply of a circuit of this receiver in case of incident, this device comprising detecting means (30, 43, 52, 48, 55, 34) emitting a signal in case of incident, and a means (36) so that this incident signal affects the charge of a capacitance (35) forming part of the delay means (35, 38) in order to interrupt the circuit only after detecting a defect of a duration at least equal to a predetermined time (t) that is represented by the voltage at the terminals of the said capacitance (35), characterised in that the said detecting means comprise means (30, 43, 52, 48, 55, 34) so that the capacitance is charged, upon the appearance of a defect only when the period impulses of short duration with respect to the period occur.

2. Device according to claim 1, characterized in that the impulses are horizontal sweeping return impulses.

3. Device according to claim 1 or 2, characterized in that the circuit interrupted in case of incident is the horizontal sweeping circuit.

4. Device according to any one of claims 1 to 3, characterized in that the delay means comprise a comparator (38) controlling the interruption of the circuit when the voltage at the terminals of the said capacitance (35) exceeds a determined value (Vref6).

5. Device according to any one of the preceding claims, characterized in that it comprises defect detectors generating signals applied on the respective inputs ($33_1$ to $33_3$) of an OR gate (34) transmitting these signals to the capacitance (35) through the intermediary of a voltage-current converter (36).

6. Device according to any one of the preceding claims, characterized in that it comprises a means (60) for maintaining the interruption of the supply of the circuit after detecting a defect of a duration superior to the said time t.

7. Device according to claims 5 and 6, characterized in that the output of the comparator (38) is connected to a supplementary input ($33_4$) of the OR gate (34).

8. Device according to any one of the preceding claims, characterized in that an intermediate capacitance (11) is in series with the vertical deviation means (1), and in that the device comprises a means (43) to emit a defect detecting signal when the average voltage at the terminals of the said intermediate capacitance exceeds a predetermined value.

9. Device according to any one of the preceding claims, characterised in that a measuring resistance (12) being in series with the vertical deviation means (1) it comprises a means (52) for generating a defect signal upon the disappearance of the voltage at the terminals of the said resistance.

10. Device according to claim 9, characterized in that the current in the vertical deviation means (1) being servo-controlled to the signal produced by an oscillator (13), the error signal of the servo-circuit being a function of the difference between the reference signal produced by the oscillator and the voltage at the terminals of the measuring resistances (12), it comprises a means (52) to produce a defect signal when the error signal exceeds a predetermined value.

11. Device according to claim 10, characterized in that the excessive value of the error signal is detected by the saturation of the amplifier (14).

12. Device according to claims 8 and 9, characterized in that the outputs of the said emitting means (43, 52) of defect detecting signals are connected to the first inputs (47, 54) of two AND gates (48, 55), the second inputs (49, 56) of which receive an impulse signal (50) of short duration with respect to the period, especially horizontal sweeping return impulses, the output of these AND gates (48, 55) being connected to respective inputs ($33_2$, $33_3$) of one OR gate (34), the output of which is connected the said capacitance (35) by the intermediary of a voltage-current converter (36).

13. Device according to any one of the preceding claims, characterized in that it comprises a means (30) for emitting a defect signal when the very high voltage (VHV) reaches an excessive value, the monitoring of this VHV being effected by the monitoring of the amplitude of the impulses of the sweeping return line.

14. Device according to any one of the preceding claims, characterized in that at least certain of its components form part of an integrated circuit also comprising components of the control device of the vertical sweeping of the television receiver.

15. Television receiver, characterized in that it comprises a device according to any one of the preceding claims.

# FIG_1

# FIG_2

FIG_3

Tension aux bornes du condensateur 11

0054452

2